# EUROPEAN PATENT SPECIFICATION

(11) **EP 0 384 301 B1**
(45) Date of publication and mention of the grant of the patent: **17.04.1996**
(21) Application number: 90102984.3
(22) Date of filing: 15.02.1990
(51) Int. Cl.: H01L 23/367, H01L 23/66

(54) **Cooling arrangement for a transistor**
Kühlungsanordnung für einen Transistor
Dispositif de refroidissement pour un transistor

(30) Priority: 17.02.1989 FI 890791
(43) Date of publication of application: 29.08.1990
(73) Proprietor: NOKIA MOBILE PHONES LTD., SF-24100 Salo (FI)
(72) Inventor: Saarnimo, Timo, SF-24260 Salo (FI)
(74) Representative: Liska, Horst, Dr.-Ing.

(56) References cited:
- DE-A- 2 801 875
- FR-A- 2 584 533
- US-A- 3 982 271
- PATENT ABSTRACTS OF JAPAN vol. 012, no. 348 (E-659)19 September 1988
- PATENT ABSTRACTS OF JAPAN vol. 005, no. 179 (E-082)17 November 1981

## Description

The present invention relates to a cooling construction for a high frequency power transistor, in which the heat of the power loss is at least mainly conducted from a semiconductor piece through a collector conductor.

These kinds of high frequency power transistors, from which the power loss turning into heat is brought out through a collector conductor, are plastic box transistors, the power loss of which is typically a few watts at the most. There are collector, emitter- and base conductors that for instance radially extend from the box, which conductors are attached on the surface of e.g a circuit board and not on the holes of a circuit board as electrical components traditionally. The construction of transistors of even higher power is completely different from these as is also the construction of low frequency transistors.

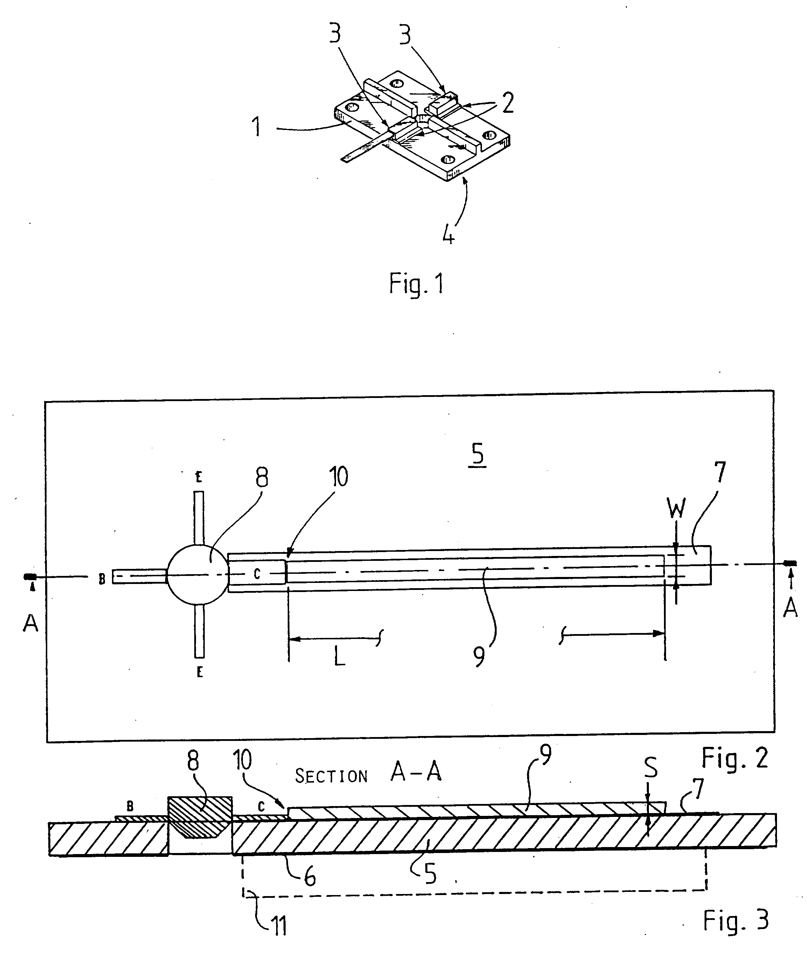

One known solution to the cooling problem of a transistor of this kind is that the transistor is placed insulated into a metal socket formed for it, to which socket ceramic pieces are attached, which pieces insulate electricity but conduct heat in order to insulate the base and the collector of the transistor from the earth potential and in order to conduct heat from the collector to the socket and to conduct heat forward from there or to evaporate it. The state of the art taken from "Motorola RF Device Data; AN-938, Motorola Inc., US, 1988; 'Mounting Techniques for Power Macro Transistor'" is illustrated in figure 1 where reference number 1 shows the socket arrangement as a whole, and reference number 2 shows the ceramic pieces, made e.g. of aluminum oxide or beryllium oxide for electrical insulation and to conduct heat, and reference number 3 shows copper elements for the attachment of the collector and the base of the transistor, and in order to attach an adjustment circuit which serves as a matching circuit to the collector. This metal socket 1 is then attached with its face 4, facing down and outwards from the transistor, to a circuit board, to which also a separate matching circuit of the high frequency power transistor is attached.-The socket 1 takes this form both in order to evaporate the power loss directly from the surface of the socket and in order to conduct heat, from its area that is considerably larger than the collector, to the circuit board in which it is conducted to a wider area and e.g. to the earth area and is thus evaporated through the circuit board.

Another method of cooling a plastic box transistor of this kind contains using, instead of a plastic, which usually is made of glass fibre epoxy, a circuit board made of a substrate material that conducts heat considerably better, such as a ceramic material, e.g. aluminum oxide.

The cooling methods presented above are efficient enough, but the one mentioned first is both complicated and difiicult to construct. It is thus also an expensive solution. There are also problems connected with the latter method, as among other things the coupling of the ceramic material flexibly and reliably to the larger surrounding circuit board and/or box. Even this solution is thus relatively expensive and difficult.

U.S. 5,214,309 shows a cooling method for a different type of transistor where the mounting surface of the transistor, i.e. a part of the casing of the transistor, serves both as a terminal and as a thermal connection for heat dissipation.

The transistor is screwed to a heat sink which serves as a carrier for both the transistor and for circuit boards. The mounting surface of the transistor is electrically connected to ground conductors of the circuit boards; two other terminals of the transistor are connected to strip line conductors on the circuit boards.

The object of the invention is to create a cooling construction for a transistor that has initially been described above, which cooling structure is both efficient and simple when considering the number of parts and their design, and thus inexpensive.

The defects mentioned above are improved considerably by a cooling construction in accordance with the invention and the defined goals are reached. In order to carry this out, the solution in accordance with the invention is characterized by what is stated in the characteristic part of claim 1.

The present invention provides a cooling construction, in which no expensive or rare materials are needed, as electric insulating materials of this kind. The present invention further provides a cooling construction, which is simple to produce, and which does neither require separate phases nor separate additional structural parts in addition to the assembly of the circuit board.

The most important advantage of the invention can be considered to be the fact that the cooling of the type of transistor that has been described is made effective by a very simple arrangement, which does neither require expensive additional structural parts nor does the assembly of the circuit board require additional phases of work.

The invention is described in more detail in the following by referring to the enclosed figures.

Figure 1 illustrates a cooling solution in accordance with the prior art.

Figure 2 illustrates a cooling solution in accordance with the invention when examined from the coupling side of the transistor towards the surface of the circuit board.

Figure 3 is the profile of the cooling solution in the figure 2.

The solution in accordance with the prior art, illustrated in figure 1, has already been described above.

Figures 2 and 3 illustrate a circuit board 5, and on one face of it the earth 6 in the earth potential, which earth is formed of a copper coating, and on the other face a matching socket 7 of the adjustment circuit, i.e. the matching circuit, also formed of the copper coating of the circuit board. The figures also illustrate the high frequency power transistor 8, which is of that type where the power loss is brought out through the collector conductor. High frequency here means radio frequencies and equal. The collector conductor of the transistor 8 is marked with the letter C, the base with B, and the emitters with the letter E and they are attached using surface mounting to the coating of the circuit board on the same side as the matching socket 7. This is not, however, an actual so called surface mounting component. The circuit board 5 can be of a traditional epoxy glass fibre type with usual metal coatingings 6, 7 on both sides. The transistor is coupled to its matching circuit, not shown and quite usual in itself, through a matching strip attached to the collector conductor of the transistor 8, which matching circuit in this case can be placed directly on the circuit board 5 using traditional circuit board technics.

According to the invention the area of the matching strip 7 is formed considerably larger than that of a traditional matching strip and in addition on the top of the matching strip and in contact with it there is a good heat conducting, thus usually made of metal, e.g. of copper, piece or a rather thick strip 9 fastened. Typically the cross section of the piece 9, which is formed of dimensions W and S, is slightly larger than the cross section of the collector conductor C of the transistor 8 and it is very long compared with the measurement or the cross section of the transistor or its structural parts. Typically the length of the piece 9 is 10-20 times its width.

The piece 9 functions as follows. The heat coming from the collector conductor C of the transistor is transferred to the piece 9 in contact with it at the point 10 both through longitudinal contact and through coating 7. Since the piece 9 is a good heat conductor, it distributes the conducted heat on the large area determined by its length and width. From here the heat is both evaporated directly from the surface of the piece 9 to the surrounding air and is also conducted to the circuit board 5 and through it to the earth side 6. From here the air can be evaporated to the surrounding air either directly from the face 6 or from a separate cooling element 11 placed against the face 6, which cooling element is illustrated in the figures only schematically using a broken line. The efficiency of the invention is thus based on the fact that the amount of air that has been conducted to the circuit board is directly proportional to the cross section, through which the heat is conducted, which cross section in this case is the area of the piece determined by the length L and the width W. Also the length L, the width W, and the thickness S of the piece or some other similar external area of the piece influences the amount of heat evaporated directly from the surface of the piece.

Using the method described above, e.g. a complicated socket or separate matching circuits attached to it, according to the prior art and shown in-figure 1, are not needed. When applying the solution of the invention, both the cooling piece 9 and the matching circuit can directly and simply be located on the circuit board 5, through the matching strip of the matching circuit. The piece 9 can simply be a piece of a copper conductor of suitable thickness, which copper conductor is attached to the circuit board by soldering, welding or by some other similar means, as all the other components, at the same phase. The metal piece 9 can also be permanently attached, e.g. by spot welding or soldering to the collector conductor C of the transistor, before installing the transistor to the circuit board.

The invention is not restricted to the form of the strip and/or the form of the piece 9 of the matching circuit shown in the figures, but its dimensions L, W and S can vary in accordance with the requirements for the cooling power and the use of space. The piece 9 does not either have to be linear, but it can be bent to form an arc or a curve or to some other suitable form. Exact values cannot be given for the dimensions of the piece 9, but they depend on the detailed structure of the transistor, the power loss, the material of the piece and the material and the dimensions of the circuit board 5. The dimensioning has to be performed so that the piece 9 is large enough to keep the temperature of the semiconductor piece of the transistor 8 low enough.

An alteration of the invention can also be considered that e.g. a suitable, very small profile or a corresponding piece is used as piece 9, in order to improve the direct convection. The piece 9 can also be made of some other material than copper, e.g. aluminum, but then its coupling technique to the matching strip has to be of a different type.

## Claims

1. High frequency power transistor (8) cooling construction, said transistor (8) having strip-like conductors for its base (B), collector (C) and emitter (E), the transistor (8) being surface mounted on a circuit board (5), heat generated by the transistor being mainly conducted from the semiconductor element of the transistor through the collector conductor (C),
said circuit board (5) having a strip-like conductive coating (7) of a matching circuit on a first surface of the board (5) contacting the collector conductor (C), and having a conductive ground coating (6) on a second surface thereof,
said cooling construction comprising a thermally conductive piece (9) solidly attached to the strip-like conductive coating (7) and contacting the collector conductor (C), the thermally conductive piece (9) being larger than the collector conductor (C) and dissipating at least a portion of the heat generated by the transistor (8).

2. Cooling construction according to claim 1, characterized in that the thermally conductive piece (9) is bar-shaped having a length (L) greater than its width (W), the length (L) extending away from the transistor (8) when it is mounted on the circuit board (5).

3. Cooling construction according to claim 2, characterized in that the length (L) is in a range of 10 to 20 times the width (W).

## Patentansprüche

1. Kühlanordnung für einen Hochfrequenz-Leistungstransistor (8), wobei der Transistor (8) für seine Basis (B), Kollektor (C) und Emitter (E) streifenartige Leiter aufweist, wobei der Transistor (8) auf einer Leiterplatte (5) oberflächenmontiert ist, wobei von dem Transistor erzeugte Wärme hauptsächlich durch den Kollektorleiter (C) von dem Halbleiterelement des Transistors abgeleitet wird,
wobei die Leiterplatte (5) eine mit dem Kollektorleiter (C) in Kontakt stehende streifenartige leitende Beschichtung (7) einer Anpassungsschaltung auf einer ersten Oberfläche der Platte (5) aufweist und eine leitende Massebeschichtung (6) auf einer zweiten Oberfläche davon aufweist,
wobei die Kühlanordnung ein fest an der streifenartigen leitenden Beschichtung (7) angebrachtes thermisch leitendes und mit dem Kollektorleiter (C) in Kontakt stehendes Teil (9) umfaßt, wobei das thermisch leitende Teil (9) größer ist als der Kollektorleiter (C) und wenigstens einen Teil der von dem Transistor (8) erzeugten Wärme dissipiert.

2. Kühlanordnung nach Anspruch 1, dadurch gekennzeichnet, daß das thermisch leitende Teil (9) stabförmig ist mit einer Länge (L), die größer ist als seine Breite (W), wobei sich die Länge (L) von dem Transistor (8) weg erstreckt, wenn es auf der Leiterplatte (5) montiert ist.

3. Kühlanordnung nach Anspruch 2, dadurch gekennzeichnet, daß die Länge (L) in einem Bereich des 10- bis 20-fachen der Breite (W) liegt.

## Revendications

1. Construction de refroidissement pour un transistor de puissance (8) à haute fréquence, ledit transistor (8) ayant des conducteurs de type bande pour sa base (B), son collecteur (C) et son émetteur (E), le transistor (8) étant monté en surface sur une carte de circuits imprimés (5), la chaleur produite par le transistor étant principalement conduite depuis l'élément semi-conducteur du transistor par le conducteur collecteur (C), ladite carte de circuits imprimés (5) ayant un revêtement conducteur (7) de type bande d'un circuit d'adaptation sur une première surface de la carte (5) en contact avec le conducteur collecteur (C), et ayant un revêtement conducteur de terre (6) sur une seconde surface de celle-ci, ladite construction de refroidissement comprenant une pièce conductrice de chaleur (9) solidement fixée au revêtement conducteur de type bande (7) et en contact avec le conducteur collecteur (C), la pièce conductrice de chaleur (9) étant plus grande que le conducteur collecteur (C) et dissipant au moins une partie de la chaleur produite par le transistor (8).

2. Construction de refroidissement selon la revendication 1, caractérisée en ce que la pièce (9) conductrice de chaleur a la forme d'une barre ayant une longueur (L) plus grande que sa largeur (W), la longueur (L) s'étendant dans une direction opposée au transistor (8) lorsqu'il est monté sur la carte de circuits imprimés (5).

3. Construction de refroidissement selon la revendication 2, caractérisée en ce que la longueur (L) se situe dans la gamme de 10 à 20 fois la largeur (W).
